# EUROPÄISCHE PATENTANMELDUNG

(11) **EP 4 675 926 A1**
(43) Veröffentlichungstag der Anmeldung: **07.01.2026**
(21) Anmeldenummer: 25161740.3
(22) Anmeldetag: 05.03.2025
(51) Int. Cl.: H03K 17/955, E05B 81/76, H03K 17/96

(54) **BETÄTIGUNGSVORRICHTUNG ZUM AUSLÖSEN EINER FUNKTION EINES FAHRZEUGES**

(30) Priorität: 02.07.2024 DE 102024118796
(71) Anmelder: Huf Hülsbeck & Fürst GmbH & Co. KG, 42551 Velbert (DE)
(72) Erfinder: Chabrowski, Christian, 45472 Mülheim (DE)

(57) **Zusammenfassung**

Betätigungsvorrichtung (2) zum Auslösen einer Funktion eines Fahrzeuges durch einen Nutzer aufweisend einen Bedienbereich(4) zum Erfassen einer manuellen Betätigung des Nutzers zur Auslösung einer Funktion des Fahrzeuges und einen kapazitiven Sensor(6) zum Erfassen einer Annäherung und/oder einer Berührung eines Nutzers, wobei der Sensor(6) eine elektrisch leitfähige Sensorelektrode(6) aufweist, wobei die Sensorelektrode(6) als ein rohrförmiger Körper, insbesondere in Form eines hohlzylindrischen Körpers, ausgebildet ist.

## Beschreibung

Die Erfindung betrifft eine Betätigungsvorrichtung zum Auslösen einer Funktion eines Fahrzeuges durch einen Nutzer.

Aus dem Stand der Technik sind Betätigungsvorrichtungen am Fahrzeug mit kapazitiven Sensoren zur Erfassung der Annäherung eines Nutzers oder Berührung durch den Nutzer bekannt. Der kapazitive Sensor kann eine Sensorelektrode und eine Steuereinheit aufweisen. Bekannte Sensorelektroden sind flach ausgebildet, um in ein Bauteil mit kleinem Bauraum eingelegt zu werden. Die Steuereinheit misst die Kapazität der Elektrode gegenüber einer Masse und wertet diese aus. Bei Annäherung einer Hand des Nutzers ändert sich das elektrische Feld vor der flachen Sensorelektrode und somit die Kapazität der Elektrode, wobei dies durch die Steuereinheit erfasst werden kann.

Aufgabe der Erfindung ist es, den kapazitiven Sensor in einer Betätigungsvorrichtung derart auszugestalten, dass die Funktionalität erweitert wird.

Die Aufgabe wird durch eine Betätigungsvorrichtung zum Auslösen einer Funktion eines Fahrzeuges durch einen Nutzer, die einen Bedienbereich zum Erfassen einer manuellen Betätigung des Nutzers zum Auslösen einer Funktion des Fahrzeuges aufweist und einen kapazitiven Sensor zum Erfassen einer Annäherung und/oder einer Berührung eines Nutzers, der eine elektrisch leitfähige Sensorelektrode aufweist, wobei die Sensorelektrode als ein rohrförmiger Körper ausgebildet ist. Insbesondere ist der rohrförmige Körper hohlzylindrisch ausgebildet. Denkbar ist auch, dass der Rohrkörper einen eckigen Querschnitt aufweist. Der Bedienbereich kann sich um ein verformbares oder bewegliches Tastenelement oder um ein feststehendes Element handeln. Beim feststehendem Element kann der Bedienbereich für den Nutzer beispielsweise durch Rillen, Licht, Schriftzug oder der gleichen gekennzeichnet werden. Der Bedienbereich kann ferner mit einem Sensor oder einem Schalter gekoppelt sein. Die derart ausgebildete Betätigungsvorrichtung ermöglicht eine kompakte Bauweise. Durch die besser strukturierte Form kann die Funktionalität, insbesondere die mechanische Funktionalität, der Sensorelektrode erweitert werden. Durch die Einstellung der axialen Länge der Sensorelektrode in der Rohrlängsrichtung kann das elektrische Feld der Sensorelektrode weiterhin näher an der Außenseite des Betätigungselements, welche dem Nutzer vom Fahrzeugaußen oder im Fahrzeuginnenraum zugänglich ist, angeordnet werden. Die Formgebung des Rohrs kann an der räumlichen Bedingung in der Betätigungsvorrichtung angepasst werden. Die Erfindung stellt eine Betätigungsvorrichtung für ein Fahrzeug bereit, vorzugsweise für ein Zugangssystem des Fahrzeuges, zum (bevorzugt automatischen) Betätigen einer Funktion (zumindest umfassend Verriegeln und/oder Entriegeln ,Öffnen einer Tür und/oder eine sicherheitsrelevante Funktion wie zum Beispiel Aktivierung einer Beleuchtung des Fahrzeugs oder Motorstart des Fahrzeugs) eines, insbesondere grifflosen, beweglichen Teils des Fahrzeugs. Das bewegliche Teil ist vorzugsweise in Form einer Tür, z.B. einer Seitentür, einer Schiebetür, oder eine Klappe, z.B. einer Heckklappe, Tank- oder Ladeklappe, oder einer Motorhaube, des Fahrzeugs ausgebildet. Betätigt der Nutzer den Bedienbereich, wird eine Funktion ausgelöst.

Vorzugsweise weist die Sensorelektrode einen Flanschabschnitt an der Endabschnittseite Sensorelektrode auf, wobei der Flanschabschnitt in Umfangsrichtung, insbesondere radial bei einem hohlzylindrischen rohrförmigen Körper, nach außen oder nach innen vom Rohrgrundkörper der Sensorelektrode hervorsteht.

Die Endabschnittseite ist zu der Außenseite der Betätigungsvorrichtung ausgerichtet. Der Flanschabschnitt vergrößert die Stirnseite des Rohrgrundkörpers und somit auch die Austrittfläche des elektrischen Feldes, dadurch wird die Detektionsfläche des kapazitiven Sensors auch vergrößert bzw. angepasst.

Vorteilhaft überlappen sich zumindest teilweise der Bedienbereich und der Erfassungsbereich der Sensorelektrode. Betätigt der Nutzer den Bedienbereich, überprüft der kapazitive Sensor, ob es nicht tatsächlich um eine bewusste Behandlung durch den Nutzer handelt und nicht um eine Fehlauslösung durch einen anderen Gegenstand.

In einer bevorzugten Ausführung der vorliegenden Erfindung weist die Betätigungsvorrichtung noch eine Leuchteinheit auf, wobei das Licht der Leuchteinheit zumindest teilweist durch den Hohlraum der Sensorelektrode austritt. Dabei ist die Sensorelektrode nicht lichtdurchlässig und dadurch ist der Austritt des Lichts wesentlich in axialer Richtung der Sensorelektrode eingeschränkt. Die Leuchteinheit ist zumindest teilweise in dem Hohlraum der Sensorelektrode vorgesehen. Die Leuchteinheit ist bei Erfassung einer zugangsberechtigten Person an der Betätigungsvorrichtung aktivierbar. Insbesondere ist die Leuchteinheit zur Ausleuchtung des Bedienbereichs vorgesehen. Dabei kann der ganze Bedienbereich beleuchtet oder nur der Randbereich des Bedienbereichs beleuchtet sein. Dadurch ist der Bedienbereich an der Betätigungsvorrichtung für den Nutzer markiert. Die Leuchteinheit umfasst beispielsweise zumindest eine Leuchtdiode. Dadurch benötigt die Leuchteinheit einen kleinen Bauraum. Insbesondere ist eine Lebensdauer der Leuchteinheit mittels Verwendung einer Leuchtdiode erhöht. Des Weiteren wird eine Überhitzung des Ausleuchtbereichs vermieden. Ferner ist es denkbar, dass in dem Hohlraum der Sensorelektrode ein weiterer Lichtleiter vorgesehen ist. Durch den weiteren Lichtleiter wird eine möglichst gleichmäßige Lichtverteilung auf dem gesamten Bedienbereich oder gezielt auf dem Randbereich des Bedienbereichs gewährleistet. In diesem Fall dient insbesondere die Außenseite des Lichtleiters, welche dem Nutzer vom Fahrzeugaußen oder im Fahrzeuginnenraum zugänglich ist, als Bedienbereich.

In einer weiteren Ausführung der vorliegenden Erfindung ist es denkbar, dass ein Schalter in der Betätigungsvorrichtung vorgesehen ist und der Bedienbereich als ein Tastenelement ausgebildet ist, welches den Schalter betätigt, wenn der Nutzer das Tastenelement betätigt. Insbesondere weist das Tastenelement einen Stößel auf, der sich im Innenraum der Betätigungsvorrichtung erstreckt und den Schalter betätigt. Dabei dient der Hohlraum der Sensorelektrode als Führung für die Bewegung des Tastenelements bzw. des Stößels. Beim Schalter kann es sich um einen mechanischen Schalter handeln, der vom Tastenelement bzw. vom Stößel gedrückt wird. Alternativ kann der Schalter auch ein Bewegungsaufnahme-Sensor sein, wie zum Beispiel ein induktiver oder ein MOC(Metal-over Cap)-Sensor sein. Dabei ist ein Aktivierungselement vorgesehen, welches mit dem Tastenelement bzw. mit dem Stößel bewegungsgekoppelt ist. Verformt sich das Tastenelement oder bewegt sich das Tastenelement durch die Betätigungshandlung durch den Nutzer, bewegt sich das Aktivierungselement relativ zum Bewegungsaufnahme-Sensor. Die Lageveränderung des Aktivierungselements zum Bewegungsaufnahme-Sensor führt zur Induktivitäts- oder Kapazitätsveränderung. Der Hohlraum der Sensorelektrode ist nach außen von dem Tastenelement verschlossen. Im nicht betätigten Zustand ist das Tastenelement bündig in der Außenseite der Betätigungsvorrichtung integriert.

Vorteilhafterweise ist es denkbar, dass die Betätigungsvorrichtung an einem Karosserieabschnitt oder auf oder in einer A-Säule oder B-Säule oder C-Säule oder D-Säule angeordnet ist. Die Vorteile bestehen insbesondere darin, dass die Betätigungsvorrichtung einen geringen Bauraum bedarf. Dadurch lassen sich unterschiedliche Fahrzeugoberflächen und/oder eine Fahrzeugaußenhaut mit einer solchen Betätigungsvorrichtung mit einem verbesserten Erscheinungsbild versehen.

Weitere Vorteile, Merkmale und Einzelheiten ergeben sich aus der nachfolgenden Beschreibung, in der gegebenenfalls unter Bezug auf die Zeichnungen Ausführungsbeispiele im Einzelnen beschrieben sind. Gleiche, ähnliche und/oder funktionsgleiche Teile sind mit gleichen Bezugszeichen versehen.
Fig. 1 ein Kraftfahrzeug mit einer erfindungsgemäßen Betätigungsvorrichtung an einer Säule
Fig. 2 die Betätigungsvorrichtung gemäß Fig. 1
Fig. 3 Schemaskizze der Querschnittsansicht einer erfindungsgemäßen Betätigungsvorrichtung gemäß der Fig. 2
Fig. 4 Schemaskizze der Querschnittsansicht einer weiteren erfindungsgemäßen Betätigungsvorrichtung gemäß der Fig. 2
Fig. 5 Schemaskizze der Querschnittsansicht einer weiteren erfindungsgemäßen Betätigungsvorrichtung gemäß der Fig. 2

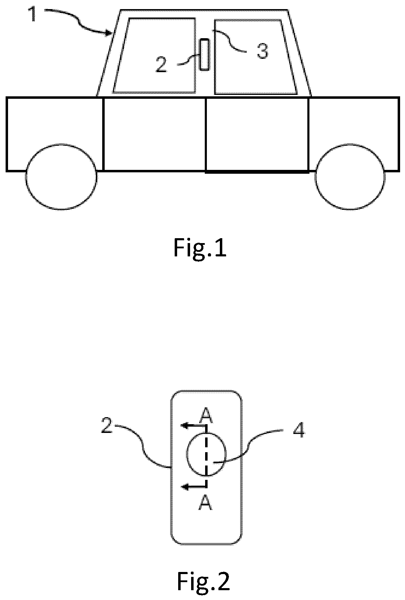

In der Fig. 1 ist ein Kraftfahrzeug 1 mit einer erfindungsgemäßen Betätigungsvorrichtung 2 an einen B-Säule 3 dargestellt, an der die vorliegende Erfindung verwirklicht ist.

Durch eine Betätigungshandlung eines Nutzers an der Betätigungsvorrichtung 2 wird ein Öffnungssignal und/oder Entriegelungssignal und/oder ein Verriegelungssignal der Tür veranlasst. Wie man aus der Fig. 2 entnehmen kann, weist die Betätigungsvorrichtung 2 an der Außenseite, welche dem Nutzer vom Fahrzeugaußen zugänglich ist, einen Bedienbereich 4 auf. Es ist auch denkbar, dass die Betätigungsvorrichtung 2 mehrere Bedienbereiche 4 umfassen kann. Der Bedienbereich 4 kann ein Tastenelement, eine Berührungsstelle oder eine Annäherungsstelle für den Nutzer sein.

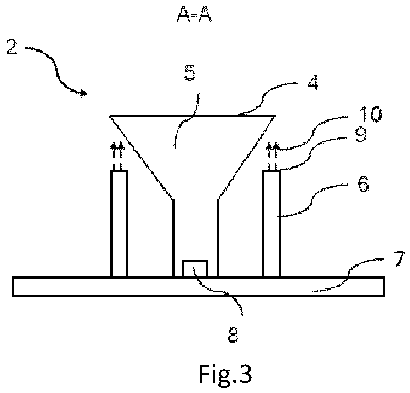

Fig. 3 zeigt die Schemaskizze der Querschnittsansicht einer erfindungsgemäßen Betätigungsvorrichtung 2 gemäß der Fig.2. Die Betätigungsvorrichtung 2 weist einen Bedienbereich 4 auf. Der Bedienbereich 4 ist als ein Teil von einem lichtdurchlässigen Lichtleiter 5 ausgebildet, der von der Außenseite der Betätigungsvorrichtung zugänglich ist. In der Betätigungsvorrichtung 2 ist noch ein kapazitiver Sensor 6 in Form einer hohlzylindrische Sensorelektrode 6 auf einer Leiterplatte 7 angeordnet. Auf der Leiterplatte 7 ist eine Lichteinheit 8 in Form einer Lichtdiode 8 vorgesehen. Die Lichteinheit 8 ist vom Lichtleiter 5 umgeben. Der Lichtleiter 5 gewährleistet eine gleichmäßige Verteilung des Lichts im Bedienbereich 4. Der Lichtleiter 5, zusammen mit der Lichteinheit 8, liegt zumindest teilweise im Hohlraum der Sensorelektrode 6. Das elektrische Feld 10 tritt aus der Stirnfläche 9 der Sensorelektrode 6 aus und ist nach der Außenseite der Betätigungsvorrichtung 2 gerichtet. Nähert sich der Nutzer mit der Hand an dem Bedienbereich 4 an, wird eine Funktion von der Betätigungshandlung auslöst, wie zum Beispiel Verriegeln des Fahrzeugschlosses.

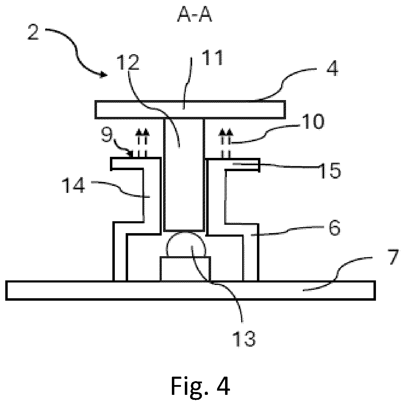

Die Fig. 4 zeigt die schematische Darstellung der Querschnittsansicht einer erfindungsgemäßen Betätigungsvorrichtung 2 gemäß der Fig.2. Die Betätigungsvorrichtung 2 weist einen Bedienbereich 4 in Form eines Tastenelement 11 auf, welchen der Nutzer drücken kann. Das Tastenelement 11 weist einen Stößel 12 auf, der nach innen hervorsteht und einen Schalter 13 auf einer Leiterplatte 7 betätigt. In der Betätigungsvorrichtung 2 ist ein kapazitiver Sensor 6 in Form einer hohlzylindrischen Sensorelektrode 6 vorgesehen. Dabei dient der Rohrgrundkörper der der Sensorelektrode 6 als eine Führung für das Tastenelement 11 bzw. den Stößel 12 des Tastenelements 11 beim Betätigen durch einen Nutzer. Der Führungsabschnitt 14 des Rohrgrundkörpers der Sensorelektrode 6 hat eine anpassende Querschnittgröße für den Stößel 12 des Tastenelements 11. Im restlichen Abschnitt kann sich die Querschnittsgröße an anderen räumlichen Bedingungen der Betätigungsvorrichtungsinnenraum anpassen. Ferner weist die Betätigungsvorrichtung 2 einen Flanschabschnitt 15 auf, welcher radial nach außen oder nach innen vom Rohrgrundkörper der Sensorelektrode hervorsteht. Der Flanschabschnitt 15 vergrößert die Stirnseite 9 des Rohrgrundkörpers somit auch die Austrittfläche des elektrischen Feldes 10. Nähert sich der Nutzer zum Beispiel mit der Hand an den Bedienbereich 4 an, wird er vom kapazitiven Sensor 6 erfasst. Drückt der Nutzer weiter das Tastenelement 11, wird der Schalter 13 ausgelöst und zum Beispiel ein Entriegelungssignal des Schlosses bzw. das Öffnungssignal eines beweglichen Teils des Fahrzeugs wird veranlasst. Dabei stellt die Erfassung durch den kapazitiven Sensor 6 eine Sicherung auf, um eine Fehlauslösung zu vermeiden, dass die Drückbetätigung nicht vom Nuzer kommt, sondern von einem zufälligen Gegenstand.

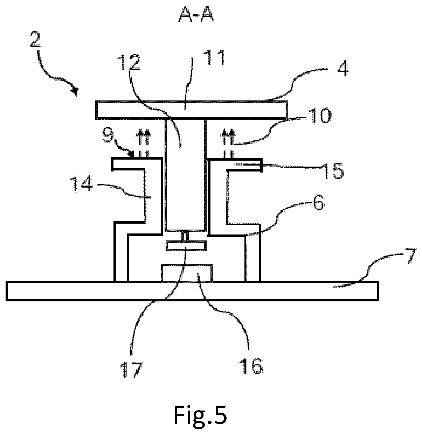

Die Fig. 5 zeigt die schematische Darstellung der Querschnittsansicht einer erfindungsgemäßen Betätigungsvorrichtung 2 gemäß der Fig.2. Im Vergleich zur Fig.4 wird hier ein Bewegungsaufnahme-Sensor 16 zum Beispiel in Form eines induktiven Sensors 16 eingesetzt. Dabei ist ein Aktivierungselement 17 vorgesehen, welches mit dem Stößel 12 des Tastenelements 11 bewegungsgekoppelt ist. Bei Berührung oder Drücken auf dem Tastenelement 11 ändert sich die Lage des Aktivierungselements 17 zum induktiven Sensor, wodurch die Betätigungshandlung erfasst wird.

Die voranstehenden Erläuterungen der Ausführungsformen beschreiben die vorliegende Erfindung ausschließlich im Rahmen von Beispielen. Selbstverständlich können einzelne Merkmale der Ausführungsformen, sofern technisch sinnvoll, frei miteinanderkombiniert werden, ohne den Rahmen der vorliegenden Erfindung zu verlassen.

## Patentansprüche

1. Betätigungsvorrichtung (2) zum Auslösen einer Funktion eines Fahrzeuges durch einen Nutzer aufweisend einen Bedienbereich(4) zum Erfassen einer manuellen Betätigung des Nutzers zur Auslösung einer Funktion des Fahrzeuges und einen kapazitiven Sensor(6) zum Erfassen einer Annäherung und/oder einer Berührung eines Nutzers, wobei der Sensor(6) eine elektrisch leitfähige Sensorelektrode(6) aufweist, **dadurch gekennzeichnet, dass** die Sensorelektrode(6) als ein rohrförmiger Körper, insbesondere in Form eines hohlzylindrischen Körpers, ausgebildet ist.

2. Betätigungsvorrichtung (2) nach Anspruch 1, **dadurch gekennzeichnet, dass** die Funktion ein Entriegeln, Verriegeln eines Türschlosses, ein Öffnen einer Fahrzeugtür und/oder eine sicherheitsrelevante Funktion.

3. Betätigungsvorrichtung (2) nach Anspruch 1 der 2, **dadurch gekennzeichnet, dass** die Sensorelektrode(6) an der Endabschnittseite der Sensorelektrode(6) einen Flanschabschnitt(15) aufweist, welcher in Umfangsrichtung nach außen oder nach innen vom Rohrgrundkörper der Sensorelektrode hervorsteht.

4. Betätigungsvorrichtung (2) nach einem der vorhergehenden Ansprüche, **dadurch gekennzeichnet, dass** der Bedienbereich(4) und der Erfassungsbereich der Sensorelektrode(6) sich zumindest teilweise überlappen.

5. Betätigungsvorrichtung (2) nach einem der vorhergehenden Ansprüche, **dadurch gekennzeichnet, dass** die Betätigungsvorrichtung (2) eine Leuchteinheit(8) aufweist und das Licht der Leuchteinheit(8) sich zumindest teilweist durch den Hohlraum der Sensorelektrode(6) austritt.

6. Betätigungsvorrichtung (2) nach Anspruch 5, **dadurch gekennzeichnet, dass** in dem Hohlraum der Sensorelektrode ein Lichtleiter(5) vorgesehen ist, insbesondere dient die Außenseite des Lichtleiters(5), welche dem Nutzer vom Fahrzeugaußen oder im Fahrzeuginnenraum zugänglich ist, als Bedienbereich.

7. Betätigungsvorrichtung (2) nach einem der vorhergehenden Ansprüche, **dadurch gekennzeichnet, dass** ein Schalter(13) in der Betätigungsvorrichtung (2) vorgesehen ist und der Bedienbereich(4) als ein Tastenelement(11) ausgebildet ist, welches den Schalter(13) betätigt, wenn der Nutzer das Tastenelement(11) betätigt, wobei der Hohlraum der Sensorelektrode(6) als Führung für die Bewegung des Tastenelements(11) dient.

8. Betätigungsvorrichtung (2) nach Anspruch 7, **dadurch gekennzeichnet, dass** der Schalter(13) als ein mechanischer Schalter ausgebildet ist, welcher vom Tastenelement (11) gedrückt wird.

9. Betätigungsvorrichtung (2) nach Anspruch 7, **dadurch gekennzeichnet, dass** der Schalter(13) als ein Bewegungsaufnahme-Sensor(16) insbesondere in Form von einem induktiven Sensor oder einem Metal-over-Cap(MoC)-Sensor ausgebildet ist, der die Bewegung eines Aktivierungselements(17) erfasst, wobei das Aktivierungselements(17) mit dem Tastenelement(11) bewegungsgekoppelt ist.

10. Betätigungsvorrichtung (2) nach einem der vorhergehenden Ansprüche, **dadurch gekennzeichnet, dass** die Betätigungsvorrichtung (2) an einem Karosserieabschnitt oder auf oder in einer A-Säule oder B-Säule oder C-Säule oder D-Säule angeordnet ist.
